# EUROPEAN PATENT APPLICATION

(11) **EP 2 579 340 A1**
(43) Date of publication of application: **10.04.2013**
(21) Application number: 11786061.9
(22) Date of filing: 21.05.2011
(51) Int. Cl.: H01L 33/36, H01L 33/42

(54) **LIGHT EMITTING DIODE STRUCTURE WITH TRANSPARENT CONDUCTIVE HEAT DISSIPATION FILM**

(30) Priority: 28.05.2010 CN 201020206889 U
(71) Applicant: JingDeZhen Fared Technology Co., Ltd, Ceramic Industrial Park Jingdezhen City, 333000 Jiangxi (CN)
(72) Inventor: CHEN, Jeong-Shiun, Jiangxi 333000 (CN)
(74) Representative: Gee, Steven William
(86) International application number: PCT/CN2011/074476
(87) International publication number: WO 2011/147289

(57) **Abstract**

An LED structure includes a sapphire substrate, an epitaxy light emitting structure, a transparent conductive heat dissipation film, a first metal contact layer and a second metal contact layer. The transparent conductive heat dissipation film is electrically conductive and thermally radiative, and has a surface microscopic crystalline structure. The heat generated by the epitaxy light emitting structure is propagated by thermal radiation in a direction from the upper surface to the lower surface of the transparent conductive heat dissipation film. The transparent conductive heat dissipation film successfully replaces the transparent ITO (indium tin oxide) film to provide similar optical and electrical feature and performs fast heat dissipation by directive thermal radiation. The heat dissipation and efficiency of light emitting are greatly improved so as to prolong the lifetime of LED and final LED products.

## Description

### BACKGROUND OF THE INVENTION

### 1. Field of the Invention

The present invention generally relates to a light emitting diode (LED) structure, and more specifically to an LED structure using a transparent conductive heat dissipation film with electrical conduction and thermal radiation to replace a traditional ITO (indium tin oxide) film.

### 2. The Prior Arts

Recently, as the technology of LED makes advanced progress and the peripheral control circuits well develope, an LED with the advantages of high lumen, low power consumption, long lifetime and high color rendering index has drawn much attention in the display and lighting industries and has been widely used in the mobile phone, the backlight module of LCD monitor and television, the projector and general lighting device.

Additionally, an LED is considered as one key part in the green industries because of power saving. Especially, the LED is mercury-free and meets the requirement of Rohs (Restriction of Hazardous Substances Directive) by European Union.

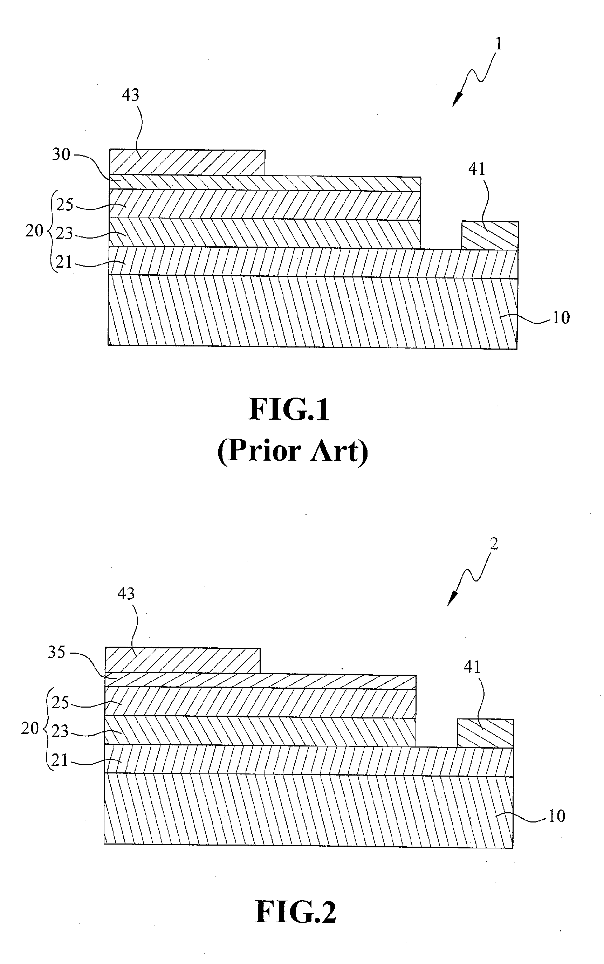

As for the traditional LED structure, please refer to FIG. 1. The LED structure 1 in the prior arts generally includes a sapphire substrate 10, an epitaxy light emitting structure 20, an ITO (indium tin oxide) layer 30, a first metal contact layer 41 and a second metal contact layer 43. The sapphire substrate 10 is electrically insulated. The epitaxy light emitting structure 20 is disposed on the sapphire substrate 10 and includes an N type semiconductor layer 21, a light emitting layer 23 and a P type semiconductor layer 25. The light emitting layer 23 is fabricated from indium gallium nitride or gallium nitride to emit light due to electron-hole recombination.

The ITO layer 30 is transparent and has electrical insulation. Generally, the ITO layer 30 is disposed on the epitaxy light emitting structure 20 and is connected to the second metal contact layer 43 as a P type contact layer such that the current supplied by an external power source (not shown) is uniformly distributed to avoid addition power consumption. The first metal contact layer 41 is ohmic contact with the N type semiconductor layer 21 and serves as an N type contact layer connected to a negative end of the external power source. The second metal contact layer 43 is ohmic contact with the upper surface of the transparent conductive heat dissipation film 35 and serves as a P type contact layer connected to a positive end of the external power source.

As high brightness LEDs have been successfully developed, the electrical power required by the LEDs becomes much higher. As a result, the working temperature of the LED dramatically increases because of poor heat dissipation in the prior arts. The lifetime of the LEDs and the LED products is thus reduced. Therefore, it is a crucial issue to improve the efficiency of heat dissipation.

The feasible solution in the prior arts is usually implemented by increasing the effective surface area for heat dissipation through thermal conduction, such as a metal plate with large area provided under the circuit board on which the LEDs are mounted. However, the direction of heat dissipation for thermal conduction is isotropic, that is, in all direction from the hotter spot, and the efficiency is low. In particular, the weight and volume of the LED structure may become considerably heavy and huge because of additional heat sinks. This causes inconvenience in actual applications. Therefore, it is desired to provide a new LED structure with a transparent heat conductive dissipation film to replace the ITO layer and implement directive heat dissipation by thermal radiation so as to overcome the above problems in the prior arts.

### SUMMARY OF THE INVENTION

Therefore, the present invention has been fabricated in view of the above problems, and it is an objective of the present invention to provide an LED structure with a transparent conductive heat dissipation film, which includes a sapphire substrate, an epitaxy light emitting structure, a transparent conductive heat dissipation film, a first metal contact layer and a second metal contact layer. The epitaxy light emitting structure is disposed on the sapphire substrate and has an N type semiconductor layer, a light emitting layer and a P type semiconductor layer such that the light emitting layer emits light by electron-hole recombination. The first metal contact layer is ohmic contact with the N type semiconductor layer and serves as an N type contact layer connected to a negative end of an external power source. The second metal contact layer is ohmic contact with the upper surface of the transparent conductive heat dissipation film and serves as a P type contact layer connected to a positive end of the external power source.

The transparent conductive heat dissipation film is disposed on the epitaxy light emitting structure, and has an upper surface and a lower surface. The lower surface of the transparent conductive heat dissipation film is electrically connected to the P type semiconductor layer and the upper surface thereof is ohmic contact with the second metal contact layer. The transparent conductive heat dissipation film has light transparency and electrical conduction and makes uniform distribution of the current flowing from the second metal contact layer to the first metal contact layer so as to avoid additional power consumption due to high current density.

The transparent conductive heat dissipation film is fabricated from a mixture of metal and nonmetal. The mixture of metal and nonmetal consists of a metal compound and a nonmetal compound, the metal compound consists of at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony. The nonmetal compound consists of at least one of oxide, nitride and inorganic acid of at least one of boron and carbon. For example, the mixture of metal and nonmetal consists of halide of titanium antimony and carbonate.

The transparent conductive heat dissipation film has a lattice structure matching the P type semiconductor layer, or forms an ohmic contact with the P type semiconductor layer. The upper surface of the transparent conductive heat dissipation film has a surface microscopic crystalline structure, which is formed of crystals having a grain size of 2 nm to 1 µm. The crystal in the transparent conductive heat dissipation film consists of global crystal or polyhedral crystal, such as pyramid octahedral crystal. Therefore, the transparent conductive heat dissipation film can propagate the heat generated by the epitaxy light emitting structure by thermal radiation in a direction from the upper surface to the lower surface of the transparent conductive heat dissipation film so as to improve the efficiency of heat dissipation.

The present invent successfully replaces the transparent ITO film by the transparent conductive heat dissipation film to provide similar optical and electrical feature and performs fast heat dissipation by directive thermal radiation. The heat dissipation and efficiency of light emitting are greatly improved so as to prolong the lifetime of LED and final LED products.

### BRIEF DESCRIPTION OF THE DRAWINGS

The present invention can be understood in more detail by reading the subsequent detailed description in conjunction with the examples and references fabricated to the accompanying drawings, wherein:

FIG. 1 is a view showing the LED structure in the prior arts; and

FIG. 2 is a schematic view showing an LED structure with a transparent conductive heat dissipation film according to one embodiment of the present invention.

### DETAILED DESCRIPTION OF THE PREFERRED EMBODIMENT

The present invention may be embodied in various forms and the details of the preferred embodiments of the present invention will be described in the subsequent content with reference to the accompanying drawings. The drawings (not to scale) show and depict only the preferred embodiments of the invention and shall not be considered as limitations to the scope of the present invention. Modifications of the shape of the present invention shall too be considered to be within the spirit of the present invention.

FIG. 2 clearly illustrates an LED structure with a transparent conductive heat dissipation film according to one embodiment of the present invention. As shown in FIG. 2, the LED structure 2 of the present invention includes a sapphire substrate 10, an epitaxy light emitting structure 20, a transparent conductive heat dissipation film 35, a first metal contact layer 41 and a second metal contact layer 43. The epitaxy light emitting structure 20 disposed on the sapphire substrate 10 emits light by electron-hole recombination, and includes an N type semiconductor layer 21, a light emitting layer 23 and a P type semiconductor layer 25. Specifically, the N type semiconductor layer 21 is fabricated from N type gallium nitride. The light emitting layer 23 is fabricated from indium gallium nitride or gallium nitride. The P type semiconductor layer 25 is fabricated from P type gallium nitride.

The first metal contact layer 41 is ohmic contact with the N type semiconductor layer 21 and serves as an N type contact layer connected to a negative end of an external power source (not shown). Similarly, the second metal contact layer 43 is ohmic contact with the upper surface of the transparent conductive heat dissipation film 35 and serves as a P type contact layer connected to a positive end of the external power source.

The transparent conductive heat dissipation film 35 is disposed on the epitaxy light emitting structure 20, and has an upper surface and a lower surface. The lower surface of the transparent conductive heat dissipation film 35 is electrically connected to the P type semiconductor layer 25 and the upper surface is ohmic contact with the second metal contact layer 43. The transparent conductive heat dissipation film 35 has light transparency and electrical conduction, and makes uniform distribution of the current flowing from the second metal contact layer 43 to the first metal contact layer 41 so as to avoid additional power consumption due to localized high current density.

The transparent conductive heat dissipation film 35 is fabricated from a mixture of metal and nonmetal, and the mixture of metal and nonmetal consists of a metal compound and a nonmetal compound. More specifically, the metal compound consists of at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony. The nonmetal compound consists of at least one of oxide, nitride and inorganic acid of at least one of boron and carbon. For example, the mixture of metal and nonmetal consists of halide of titanium antimony and carbonate.

The transparent conductive heat dissipation film 35 has a lattice structure, which matches the P type semiconductor layer 25, or forms an ohmic contact with the P type semiconductor layer 25. Furthermore, the upper surface of the transparent conductive heat dissipation film 35 has a surface microscopic crystalline structure, which is preferably formed of crystals having a grain size of 2 nm to 1 µm. The crystal in the transparent conductive heat dissipation film consists of global crystal or polyhedral crystal, such as pyramid octahedral crystal. The transparent conductive heat dissipation film 35 propagates the heat generated by the epitaxy light emitting structure 20 by thermal radiation in a direction from the upper surface to the lower surface of the transparent conductive heat dissipation film 35 so as to improve the efficiency of heat dissipation.

Additionally, the LED structure 2 of the present invention further includes package layer (not shown) to package the epitaxy light emitting structure 20, the transparent conductive heat dissipation film 35, the first metal contact layer 41 and the second metal contact layer 43 so as to provide protection and the function of adjusting color temperature (CT) for the emitting light.

One aspect of the present invention is that the transparent ITO film is replaced by the transparent conductive heat dissipation film providing similar optical and electrical feature so as to perform fast heat dissipation by directive thermal radiation. With high efficiency of heat dissipation of the transparent conductive heat dissipation film, the heat generated by the epitaxy light emitting structure is fastly propagated without any thermally conductive medium. Therefore, the heat dissipation and efficiency of light emitting are greatly improved so as to prolong the lifetime of LED and final LED products.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

## Claims

1. A light emitting diode (LED) structure with a transparent conductive heat dissipation film, comprising:
a sapphire substrate with electrical insulation;
an epitaxy light emitting structure disposed on the sapphire substrate for emitting light, the epitaxy light emitting structure including an N type semiconductor layer, a light emitting layer and a P type semiconductor layer;
a transparent conductive heat dissipation film provided on the epitaxy light emitting structure and having an upper surface and a lower surface opposite to the upper surface, wherein the lower surface of the transparent conductive heat dissipation film is electrically connected to the P type semiconductor layer, the transparent conductive heat dissipation film having light transparency and electrical conduction and fabricated from a mixture of metal and nonmetal, the upper surface of the transparent conductive heat dissipation film having a surface microscopic crystalline structure with crystals;
a first metal contact layer in contact with the N type semiconductor layer serving as an N type contact layer connected to a negative end of an external power source; and
a second metal contact layer being ohmic contact with the upper surface of the transparent conductive heat dissipation film and serving as a P type contact layer connected to a positive end of the external power source.

2. The LED structure as claimed in claim 1, wherein the N type semiconductor layer is fabricated from N type gallium nitride, the light emitting layer is formed of indium gallium nitride or gallium nitride, and the P type semiconductor layer is fabricated from P type gallium nitride.

3. The LED structure as claimed in claim 1, wherein the mixture of metal and nonmetal consists of a metal compound and a nonmetal compound, the metal compound consists of at least one of silver, copper, tin, aluminum, titanium, iron and antimony, or at least one alloy of silver, copper, tin, aluminum, titanium, iron and antimony, or at least one oxide or halide of silver, copper, tin, aluminum, titanium, iron and antimony, and the nonmetal compound consists of least one of oxide, nitride and inorganic acid of at least one of boron and carbon.

4. The LED structure as claimed in claim 1, wherein the crystal in the transparent conductive heat dissipation film consists of global crystal or polyhedral crystal, and the crystal has a grain size of 2 nm to 1 µm.

5. The LED structure as claimed in claim 4, wherein the polyhedral crystal consists of pyramid octahedral crystal.

6. The LED structure as claimed in claim 1, wherein the transparent conductive heat dissipation film has a lattice structure matching the P type semiconductor layer, or forms an ohmic contact with the P type semiconductor layer.

7. The LED structure as claimed in claim 1, wherein the surface microscopic crystalline structure in the transparent conductive heat dissipation film propagates heat generated by the epitaxy light emitting structure by thermal radiation in a direction from the upper surface to the lower surface of the transparent conductive heat dissipation film.

8. The LED structure as claimed in claim 1, further comprising a package layer to package the epitaxy light emitting structure, the transparent conductive heat dissipation film, the first metal contact layer and the second metal contact layer.
